# EUROPÄISCHE PATENTSCHRIFT

(11) **EP 2 476 300 B1**
(45) Veröffentlichungstag und Bekanntmachung des Hinweises auf die Patenterteilung: **06.11.2013**
(21) Anmeldenummer: 10752750.9
(22) Anmeldetag: 01.09.2010
(51) Int. Cl.: H05K 5/06

(54) **ELEKTRONIKEINHEIT UND VERFAHREN ZUM HERSTELLEN DERSELBEN**
ELECTRONIC UNIT AND METHOD FOR PRODUCING THE SAME
UNITÉ ÉLECTRONIQUE ET PROCÉDÉ DE FABRICATION ASSOCIÉ

(30) Priorität: 08.09.2009 DE 102009029260
(43) Veröffentlichungstag der Anmeldung: 18.07.2012
(73) Patentinhaber: Robert Bosch GmbH, 70442 Stuttgart (DE)
(72) Erfinder: GUYENOT, Michael, 71638 Ludwigsburg (DE); DONIS, Dieter, 70439 Stuttgart (DE); SCHMID, Stefan, 75181 Pforzheim (DE); BIRKHOLD, Andreas, 70499 Stuttgart (DE)
(86) Internationale Anmeldenummer: PCT/EP2010/062777
(87) Internationale Veröffentlichungsnummer: WO 2011/029755

(56) Entgegenhaltungen:
- EP-A2- 1 581 037
- GB-A- 1 047 411
- US-A- 5 075 821
- ANONYMOUS: "Sleeve cap for edge-connected modules", RESEARCH DISCLOSURE, MASON PUBLICATIONS, HAMPSHIRE, GB, Bd. 306, Nr. 63, 1. Oktober 1989 (1989-10-01), XP007114285, ISSN: 0374-4353

## Beschreibung

Die vorliegende Erfindung betrifft eine Elektronikeinheit, umfassend eine mit wenigstens einem elektronischen Bauelement und einer Leiterplattendirektkontaktierung bestückte Leiterplatte, wobei die Leiterplatte in einem Gehäuse angeordnet ist, das mit einem wärmeleitenden Medium befüllt ist.

### Stand der Technik

Nahezu jedes elektronische Gerät weist eine Elektronikeinheit mit einer oder mehreren Leiterplatten bzw. Schaltungsträgern auf. Leiterplatten sind Träger für elektronische Bauelemente. Diese elektronischen Bauelemente sind auf der Leiterplatte mechanisch befestigt und elektrisch miteinander verbunden. Als elektronische Bauelemente kommen insbesondere Induktivitäten, Spulen, kleine Kapazitäten, Kontakte oder Widerstände in Betracht. Auch sind auf Leiterplatten oftmals direkt integrierte Schaltkreise, also Mikrochips angeordnet.

Die Leiterplatten sind aus einem elektrisch isolierenden Material, wie Kunststoff, hergestellt. Dazu werden vorwiegend Produkte aus einem Harz und Papier oder einem Glasfasergewebe verwendet. Alternativ können als Material für die Herstellung von Leiterplatten bzw. Schaltungsträgern auch Teflon oder Keramiken, wie Aluminiumoxidkeramiken und LTCC, verwendet werden.

Auf der Leiterplatte sind zur elektrischen Verbindung der elektronischen Bauelemente oftmals Kupferleitungen vorgesehen, die fotolithografisch oder durch Fräsen hergestellt und galvanisch verstärkt werden können. Beim Gebrauch der Leiterplatten fließt durch die elektrischen Leitungen und die elektronischen Bauelemente Strom. Es ist hinlänglich bekannt, dass in elektrischen Leitungen ein Leitungsverlust durch deren Widerstand entsteht, der als Joulesche Wärme oder Stromwärme bezeichnet wird und das elektrische System erwärmt.

Die Joulesche Wärme ist für die Leiterplatten bzw. die elektronischen Bauelemente jedoch problematisch. Denn gerade bei elektronischen Bauelementen ist es in der Praxis nicht nur wichtig, die Arbeitstemperatur im Mittel unterhalb einer bestimmten Materialtemperatur zu halten, oberhalb der das Material irreversibel geschädigt oder zerstört werden kann. Vielmehr ist auch darauf zu achten, dass das Auftreten von Temperaturspitzen vermieden wird. Dies folgt aus einem nahezu exponentiellen Zusammenhang zwischen der Temperaturbelastung und der Lebensdauer der elektronischen Bauelemente. Das bedeutet, das schon bei einer vergleichsweise geringen Erhöhung der Arbeitstemperatur die Lebensdauer der elektronischen Bauelemente drastisch verkürzt werden kann. Somit wird klar, dass die entstehende Wärme, sowohl im Mittel, als auch Temperaturspitzen, zuverlässig abgeführt und die elektronischen Bauelemente dadurch gekühlt werden müssen.

Um eine Wärmeableitung bzw. Kühlung zu gewährleisten, ist es bekannt, Glas als Material für die Leiterplatte zu verwenden. Zudem ist es bekannt, mehrlagige Leiterplatten zu verwenden, bei denen in die Ober- bzw. Unterseite der einzelnen Lagen feine Nuten eingearbeitet sind, die nach dem Zusammenfügen der einzelnen Lagen kleine Kühlkanäle ausbilden, so dass die Leiterplatten mit Kühlwasser kühlbar sind. Es ist ferner bekannt, duch eine thermische Anbindung an die Umgebung spezifische Wärmeableitungen vorzusehen. Die vorbeschriebenen Arten von Leiterplatten sind jedoch kompliziert im Aufbau und damit aufwändig und kostenintensiv herzustellen. Darüber hinaus ist die Kühlleistung nicht immer zufriedenstellend.

Es ist ferner bekannt, um Leiterplatten bzw. die darauf befindlichen elektronischen Bauelemente zu kühlen, eine Elektronikeinheit auszubilden, in der die Leiterplatte in einem Gehäuse angeordnet ist, wobei das Gehäuse mit einem gut wärmeleitenden Medium gefüllt ist. Auf diese Weise kann die an den Bauelementen entstehende Wärme zuverlässig und gleichmäßig von dieser an die Umgebung abgeführt und die Bauelemente so gekühlt werden. Als besonders vorteilhaft hat es sich dabei erwiesen, wenn als gut wärmeleitendes Medium ein pulverförmiger Füllstoff verwendet wird. Dieser Füllstoff wird meist in fertig montiertem Zustand der Elektronikeinheit durch eine verschließbare Öffnung des Gehäuses eingefüllt.

Dies ist jedoch vor allem bei solchen Elektronikeinheiten problematisch, die eine Leiterplatte mit einer Leiterplattendirektkontaktierung aufweisen. Eine Leiterplattendirektkontaktierung ist eine Schnittstelle der Leiterplatte, durch die eine direkte Verbindung mit einer entgegengesetzten Schnittstelle einer weiteren Elektronikeinheit bzw. elektronischen Geräten, wie Computern oder Auswerteeinheiten, herstellbar ist. Insbesondere ist eine Leiterplattendirektkontaktierung ein Stecker, der in eine entsprechende Buchse einsteckbar ist. Derartige Elektronikeinheiten sind insbesondere in der Consumer Electronic und dem Unterhaltungssektor bekannt und verbreitet. Erste Anwendungen im Automobilsektor sind bekannt.

Damit eine derartige Leiterplattendirektkontaktierung wie gewünscht verwendbar ist, muss sie jederzeit von außerhalb des Gehäuses zugänglich sein. Am einfachsten wird dies realisiert, indem die Steckverbindung nach außen aus dem Gehäuse herausragt. Dann ist die Leiterplattendirektkontaktierung jedoch mechanischen Beanspruchungen ausgesetzt. Deshalb ist es bevorzugt, wenn die Leiterplattendirektkontaktierung von Gehäuseteilen umgeben ist, so dass ein Schutz vor mechanischer Beanspruchung gewährleistet ist.

Problematisch bei Elektronikeinheiten mit einer Leiterplattendirektkontaktierung ist es, dass die Kontaktstelle freiliegen muss, wohingegen die elektronischen Bauelemente vollständig von wärmeleitendem Medium umgeben sein sollten. Somit ist zwischen der Leiterplatte und dem Gehäuse eine Dichtung notwendig, um so ein Austreten des wärmeleitenden Mediums aus dem Gehäuse zu verhindern. Ein zuverlässiges Fixieren des wärmeleitenden Mediums in dem Gehäuse sowie ein vollständiges Abdichten bzw. Verschließen des mit dem Medium gefüllten Innenraums des Gehäuses ist durch eine hier zum Einsatz kommende Dichtung nur schwer zu realisieren. Sobald jedoch wärmeleitendes Medium aus dem Gehäuse austritt, ist eine ausreichende Wärmeableitung nicht mehr gewährleistet, die Lebensdauer der Elektronikeinheit wird deutlich verkürzt.

Aufgabe der vorliegenden Erfindung ist es, eine Elektronikeinheit mit einer Leiterplattendirektkontaktierung zu schaffen, die eine zuverlässige Kühlung aufweist und ferner einfach in der Herstellung ist und eine lange Lebensdauer besitzt.

### Offenbarung der Erfindung

Diese Aufgabe wird durch eine Elektronikeinheit mit den Merkmalen des Anspruchs 1 sowie durch ein Verfahren zum Herstellen einer Elektronikeinheit mit den Merkmalen des Anspruchs 5 gelöst.

Erfindungsgemäß ist ein Verschlusspfropfen vorgesehen, der aus einer Klebstoffschicht gebildet ist. Dadurch ist der Verschlusspfropfen besonders einfach und kostengünstig herstellbar. Ferner erlangt der Verschlusspfropfen seine abschließenden festen Eigenschaften erst, nachdem er ausgehärtet ist. Somit ist der Verschlusspfropfen unabhängig von der Geometrie bzw. Dicke der Leiterplatte oder des Gehäuses ausbildbar.

Dadurch, dass der Verschlusspfropfen einen Kontaktbereich mit der Leiterplattendirektkontaktierung von einem Schaltungsbereich mit dem mindestens einen elektronischen Bauelement abgrenzt, ist zuverlässig gewährleistet, dass das wärmeleitende Medium in dem Gehäuse sicher fixiert ist. Auf diese Weise kann ausgeschlossen werden, dass wärmeleitendes Medium aus dem Gehäuse austritt. Eventuelle Undichtigkeiten, wie sie bei Dichtungen von Elektronikeinheiten, wie sie aus dem Stand der Technik bekannt sind, vorkommen, werden so vermieden. Insbesondere, wenn das wärmeleitende Medium ein Pulver ist, ist sichergestellt, dass das Pulver nicht aus dem Gehäuse herausrieselt.

Auf diese Weise sind die elektronischen Bauelemente stets vollständig von dem wärmeleitenden Medium umgeben, wodurch eine ausreichende Wärmeableitung bzw. Kühlung gewährleistet ist. Eine erhöhte Temperatur, sowohl im Mittel, als auch Temperaturspitzen, können so ausgeschlossen werden. Dagegen ist ein Kontakt der Leiterplattendirektkontaktierung mit dem wärmeleitenden Medium ausgeschlossen, so dass die Kontaktstelle immer frei zugänglich ist und problemlos eine Verbindung mit einer anderen Elektronikeinheit ausbilden kann.

Darüber hinaus sind die elektronischen Bauelemente, welche sich auf der Leiterplatte befinden, meist sehr empfindlich. Durch die zuverlässige Umgebung der elektronischen Bauelemente mit dem wärmeleitenden Medium sind diese so zusätzlich dauerhaft vor mechanischen Beanspruchungen geschützt, was die Lebensdauer von erfindungsgemäßen Elektronikeinheiten weiter verbessert. Somit ist eine erfindungsgemäße Elektronikeinheit bzw. eine Elektronikeinheit die nach dem erfindungsgemäßen Verfahren hergestellt wurde besonders einfach und kostengünstig herzustellen und besitzt ferner ein lange Lebensdauer.

Die Erfindung wird anhand der nachfolgenden Zeichnungen näher erläutert.
Es zeigen:
Fig. 1 eine Schnittdarstellung der erfindungsgemäßen Elektronikeinheit während des Befüllvorgangs mit wärmeleitendem Medium,
Fig. 2 eine Schnittdarstellung der erfindungsgemäßen Elektronikeinheit während des Befüllvorgangs mit Klebstoff,
Fig. 3 eine Schnittdarstellung der fertiggestellten erfindungsgemäßen Elektronikeinheit.

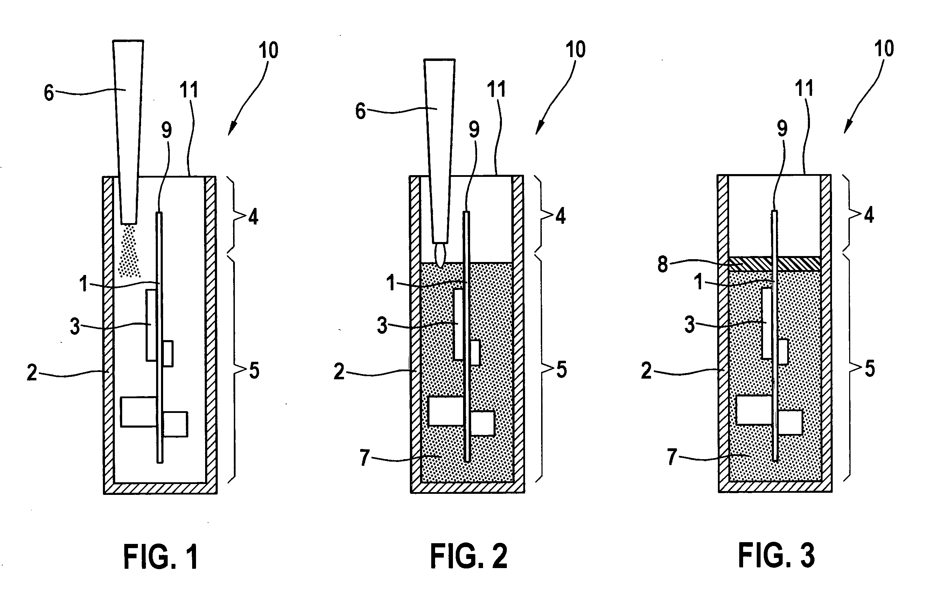

In Fig. 1 ist eine Elektronikeinheit 10 mit einem Schaltungsträger bzw. einer Leiterplatte 1 dargestellt. Die Leiterplatte 1 kann aus Kunststoffen, wie Harzen, und Papier oder Glasfaserwerkstoffen, ausgebildet sein. Es ist aber auch möglich, die Leiterplatte 1 bzw. den Schaltungsträger aus anderen aus dem Stand der Technik bekannten Materialien herzustellen. Hier ist insbesondere Keramik, vorzugsweise Aluminiumoxidkeramik, von Bedeutung. Wichtig ist vor allem, dass die Leiterplatte 1 aus einem elektrisch isolierenden Werkstoff hergestellt ist, um einen Kurzschluss zu verhindern. An der Leiterplatte 1 ist wenigstens ein, meist jedoch mehrere elektronische Bauelemente 3 vorgesehen, die mit der Leiterplatte 1 mechanisch verbunden sind. Im folgenden wird davon ausgegangen, dass an der Leiterplatte 1 mehrere elektronische Bauelemente 3 vorhanden sind. Die folgende Erläuterung der Erfindung gilt jedoch gleichermaßen für eine Elektronikeinheit 10 mit einer Leiterplatte1, die nur ein elektronisches Bauelement 3 umfasst. Beispielsweise können diese elektronischen Bauelemente 3 Induktivitäten, Spulen, kleine Kapazitäten, Kontakte oder Widerstände wie auch integrierte Schaltkreise sein. Die elektronischen Bauelemente 3, die auf Leiterplatten 1 angeordnet werden, sind aus dem Stand der Technik hinlänglich bekannt und werden hier nicht näher beschrieben. Die elektronischen Bauelemente 3 sind in einem Schaltungsbereich 5 der Elektronikeinheit 10 angeordnet.

Neben diesem Schaltungsbereich 5 mit den elektronischen Bauelementen 3 umfasst die Elektronikeinheit 10 ferner einen Kontaktbereich 4. In dem Kontaktbereich 4 weist die Leiterplatte 1 eine Leiterplattendirektkontaktierung 9 auf. Diese Leiterplattendirektkontaktierung 9 dient dazu, die Leiterplatte 1 und damit die Elektronikeinheit 10 mit anderen elektronischen Geräten, wie etwa einem Computer oder ähnlichem, zu verbinden. Hierzu ist die Leiterplattendirektkontaktierung 9 vorzugsweise ein Direktstecker, der zum Ausbilden einer Steckverbindung dient. Dies ist eine besonders einfache und leicht zu (de-) montierende elektrische Verbindung. Eine derartige Steckverbindung ist insbesondere bei Steuergeräten in verschiedensten Bereichen der Consumer Electronic und der Unterhaltungselektronik weit verbreitet. Erste Anwendungen im Automobilsektor sind bekannt.

Die mit den elektronischen Bauelementen 3 bestückte Leiterplatte 1 ist in einem Gehäuse 2 angeordnet. Das Gehäuse 2 kann zweiteilig ausgebildet sein. Dann umfasst es einen Boden und einen Deckel. Alternativ kann das Gehäuse 2 auch einstückig als Einschubgehäuse ausgebildet sein. Das Gehäuse 2 weist an einer seiner Seiten eine Stecköffnung 11 für die Leiterplattendirektkontaktierung 9 auf. Ansonsten ist das Gehäuse 2 im wesentlichen geschlossen. Darüber hinaus ist das Gehäuse 2 üblicherweise aus Metall oder einem Kunststoffwerkstoff ausgebildet. "

Im Schaltungsbereich 5 der Elektronikeinheit 10 entsteht in den elektrischen Leitungen der Leiterplatte 1 bzw. der elektronischen Bauelemente 3 beim Betrieb der Elektronikeinheit 10 Joulesche Wärme, wie dies bereits beschrieben wurde. Um diese Wärme abzuführen und insbesondere die elektronischen Bauelemente 3 dadurch zu kühlen, wird der zwischen den elektronischen Bauelementen 3 und dem Gehäuse 2 angeordnete Hohlraum mit einem wärmeleitenden Medium 7 gefüllt. Besonders vorteilhaft ist es, wenn das wärmeleitende Medium ein pulverförmiges Medium 7 ist. Ein pulverförmiges wärmeleitendes Medium 7 ist in der Regel einfach und kostengünstig herzustellen. Darüber hinaus ist es möglich, ein pulvriges wärmeleitendes Medium 7 fast beliebig feinkörnig zu gestalten, wodurch eine große Oberfläche des Pulvers entsteht und die Wärmeabführung und dadurch die Kühlleistung stark verbessert wird.

Darüber hinaus ist es von Vorteil, als wärmeleitendes Medium 7 ein Keramikpulver zu verwenden. Denn Keramikpulver hat die Eigenschaft, dass es elektrisch isolierend wirkt, ein Kurzschluss der Elektronikeinheit 10 während des Gebrauchs somit verhindert wird. Neben seiner Eigenschaft als elektrischer Isolator besitzt Keramik jedoch den weiteren Vorteil, dass es eine ausreichende thermische Leitfähigkeit besitzt, um die an den elektronischen Bauelementen 3 bzw. der Leiterplatte 1 entstehende Wärme gut abzuführen und diese so zu kühlen. Auf der anderen Seite ist die thermische Leitfähigkeit jedoch geringer als die von vielen Metallen, insbesondere Kupfer, was als Wärmeleiter aus dem Stand der Technik bekannt ist. Dadurch wird in Keramikpulver als Wärmeleiter eine zur Vermeidung einer Temperaturspitze eingespeicherte Energie langsam wieder an die Umgebung abgegeben, wodurch die Leiterplatte 1 und die elektronischen Bauelemente 3 kaum belastet werden.

Um den gewünschten Kühleffekt zu erzeugen, ist es wichtig, dass die elektronischen Bauelemente 3 im wesentlichen vollständig von dem wärmeleitenden Medium 7 eingehaust sind. Auf diese Weise entsteht eine räumliche Kühlung, so dass die Wärme dreidimensional abgeleitet wird.

Damit die elektronischen Bauelemente 3 stets ausreichend gekühlt sind und kein wärmeleitendes Medium austritt, ist ein Verschlusspfropfen 8 vorgesehen. Der Verschlusspfropfen 8 ist aus einem Klebstoff, vorzugsweise aus einem selbsthärtenden Klebstoff, ausgebildet und so an jede Dimension und/oder Form der Leiterplatte 1 bzw. des Gehäuses 2 anpassbar. Darüber hinaus grenzt der Verschlusspfropfen 8 den Kontaktbereich 4 wirksam von dem Schaltungsbereich 5 ab, so dass das wärmeleitende Medium 7 sicher in dem Schaltungsbereich 5 verbleibt und hier seine Kühlwirkung entfaltet, die Leiterplattendirektkontaktierung 9 daher nicht von dem wärmeleitenden Medium 7 verschmutzt oder verdeckt wird.

Die erfindungsgemäße Elektronikeinheit 10 wird wie folgt hergestellt. Zunächst wird das Gehäuse 2 im wesentlichen vertikal ausgerichtet. Dann befindet sich an seiner Oberseite eine Stecköffnung 11, in welche das wärmeleitende Medium 7 vorzugsweise mittels einer Dosiernadel 6 eingefüllt werden kann. Bei einer Elektronikeinheit 10 gemäß der vorliegenden Erfindung besteht durch einen im wesentlichen symmetrischen Aufbau der Leiterplattendirektkontaktierung 9 die Möglichkeit des Einbringens des wärmeleitenden Mediums 7 durch die Stecköffnung 11 des Gehäuses 2 beidseitig der Leiterplattendirektkontaktierung 9 bzw. der Leiterplatte 1. Dadurch kann ein sehr gutes Füllergebnis erzielt werden. Um die Verteilung des Mediums 7 bzw. dessen Verdichtungsgrad zu verbessern, ist es vorteilhaft, das Gehäuse 2 während des Befüllvorgangs zu rütteln. Auf diese Weise wird sichergestellt, dass die elektronischen Bauelemente 3 vollständig und ohne den Einschluss von thermisch isolierenden Luftlöchern von dem wärmeleitenden Medium 7 umgeben sind. Dadurch wird eine gute Wärmeableitung der an der Leiterplatte 1 bzw. den elektronischen Bauelementen 3 entstehenden Wärme gewährleistet. Allerdings ist darauf zu achten, dass die Leiterplattendirektkontaktierung 9 der Leiterplatte 1 nicht durch das Medium 7 bedeckt ist, damit die Ausbildbarkeit einer Steckverbindung gewährleistet bleibt.

Wenn eine solche Füllhöhe erreicht ist, muss das Gehäuse 2 an seiner Stecköffnung 11 verschlossen bzw. abgedichtet werden, wie dies in Fig. 2 gezeigt ist, um das Medium 7 in dem Gehäuse 2 sicher zu fixieren. Hierzu wird erfindungsgemäß auf die Oberfläche des Mediums 7 eine Klebstoffschicht aufgetragen, beispielsweise durch Dispensen. Der Klebstoff kann mit derselben Dosiernadel 6 in das Gehäuse 2 durch seine Stecköffnung 11 eingefügt werden, wie auch das Medium 7. Alternativ können auch zwei verschiedene Dosiernadeln 6 verwendet werden. Dadurch ist sichergestellt, dass das jeweils einzufüllende Material nicht von dem jeweils anderen Material verschmutzt wird.

Bei der Auswahl des Klebstoffs sollte dieser an die Eigenschaften des wärmeleitenden Mediums 7 angepasst werden. Insbesondere sollte der Klebstoff eine geeignete Viskosität besitzen, damit vermieden wird, dass zu viel Klebstoff in das Innere des Mediums 7 eindringt, vorzugsweise wird dies ganz vermieden. Denn wenn sich der Klebstoff mit dem wärmeleitenden Medium 7 vermischt, werden die positiven Eigenschaften des Mediums 7 durch das Entstehen eines heterogenen Gemisches verschlechtert.

Bei der erfindungsgemäßen Befüllung des Gehäuses 2 mit Klebstoff ist darauf zu achten, dass dieser die Oberfläche des Mediums 7 vollständig bedeckt. Nach dem Aushärten des Klebstoffs bildet dieser so einen Verschlusspfropfen 8 aus, der die Stecköffnung 11 des Gehäuses 2 vollständig verschließt und abdichtet. Somit grenzt der Verschlusspfropfen 8 den Kontaktbereich 4 mit der Leiterplattendirektkontaktierung 9 von dem Schaltungsbereich 5 mit den elektronischen Bauelementen 3 wirksam von einander ab. Das wärmeleitende Medium 7 wird so in dem Schaltungsbereich 5 der Elektronikeinheit 10 fixiert. Auf diese Weise kann ein ungewolltes Austreten von wärmeleitendem Medium 7 sicher verhindert werden und eine ausreichende Kühlung ist stets gewährleistet. Auf der anderen Seite ist sichergestellt, dass die Leiterplattendirektkontaktierung 9 gut von außen zugänglich bleibt und nicht von dem wärmeleitenden Medium verschmutzt wird.

Dies ist besonders wichtig, da gerade Elektronikeinheiten 10 mit einer Leiterplattendirektkontaktierung 9 oftmals nicht offen und gut sichtbar verbaut werden, sondern vielmehr geschützt und verdeckt angeordnet sind. Deshalb würde ein eventueller Verlust von wärmeleitendem Medium 7 von dem Benutzer der Elektronikeinheit 10 nicht festgestellt werden können. Durch einen potentiellen Austritt von wärmeleitendem Medium 7 aus dem Gehäuse 2 wären einzelne Bereiche der elektronischen Bauelemente 3 oder gesamte Bauelemente 3 nicht mehr in Kontakt mit wärmeleitendem Medium 7. Das hätte zur Folge, dass Temperaturerhöhungen und/oder Temperaturspitzen ungemindert auf die elektronischen Bauelemente 3 einwirken würden. Das würde aus obengenannten Gründen zu einer starken Einschränkung der Lebensdauer der Elektronikeinheit 10 führen. Wenn einzelne elektronische Bauelemente 3 zerstört sind, ist es dabei oftmals notwendig die gesamte Elektronikeinheit 10 auszutauschen, was für den Benutzer kostenintensiv ist.

Eine erfindungsgemäß hergestellte Elektronikeinheit 10 ist ferner sehr flexibel einsetzbar, da sich das wärmeleitende Medium 7 problemlos an unterschiedlichste Leiterplatten 1 und Bauelemente 3 anpasst. Die erfindungsgemäße Elektronikeinheit 10 ist somit unabhängig von Geometrie, Dicke und Abmessungen der Leiterplatte 1 bzw. der daran befestigten elektronischen Bauelemente 3 sowie deren Anzahl und Konfiguration herstellbar. Unabhängig von diesen Variablen ist stets ein zuverlässiges Umfließen der Leiterplatte 1 bzw. der elektronischen Bauelemente 3 von dem wärmeleitenden Medium 7 gesichert. Es ist bei der Herstellung der erfindungsgemäßen Elektronikeinheit 10 nicht notwendig, mehrere Kühlelemente vorzusehen, die an jedes einzelne Bauelement 3 angepasst werden müssen, wie dies oftmals im Stand der Technik der Fall war. Vielmehr muss nur ein einziges wärmeleitendes Medium 7 verwendet werden, mit dem eine ausreichende Wärmeableitung von der Leiterplatte 1 bzw. den elektronischen Bauelementen 3 stets zuverlässig gesichert ist. Das Auftreten auch von lokalen Temperaturspitzen wird nahezu ausgeschlossen, da diese gerade dann auftreten, wenn die Leiterplatte 1 bzw. die elektronischen Bauelemente 3 gerade nicht zuverlässig von dem wärmeableitenden Medium 7 umgeben sind, wie dies bei den Lösungen aus dem Stand der Technik der Fall sein kann. Auf diese Weise wird die Lebensdauer und die Zuverlässigkeit der erfindungsgemäßen Elektronikeinheiten 10 verbessert.

Aus der erfindungsgemäßen Herstellung der Elektronikeinheit 10 unabhängig von der Art der Leiterplatten 1 bzw. den elektronischen Bauelementen 3 folgt weiterhin, dass die Verwendung eines Baukastensystems ermöglicht wird, was die Herstellungskosten der erfindungsgemäßen Elektronikeinheit 10 erheblich senkt. Dies war mit den Lösungen, die aus dem Stand der Technik bekannt sind, bislang nicht möglich.

Eine weitere Erleichterung ergibt sich ferner bei einem potentiell notwendigen Austausch der Leiterplatte 1. Hierzu muss lediglich die Klebstoffschicht entfernt werden, wonach das wärmeleitende Medium 7 problemlos und rückstandsfrei aus dem Gehäuse 2 entfernen kann. Folglich kann mit demselben Gehäuse und einer neuen, mit elektronischen Bauelementen 3 bestückten Leiterplatte 1 eine neue Elektronikeinheit 10 gemäß dem erfindungsgemäßen Verfahren hergestellt werden. Dies führt zu einer weiteren Kostenersparnis.

## Patentansprüche

1. Elektronikeinheit (10), umfassend eine mit wenigstens einem elektronischen Bauelement (3) und einer Leiterplattendirektkontaktierung (9) bestückte Leiterplatte (1), wobei die Leiterplatte (1) in einem Gehäuse (2) angeordnet ist, das mit einem wärmeleitenden Medium (7) befüllt ist, **dadurch gekennzeichnet, dass** ein Verschlusspfropfen (8) vorgesehen ist, der aus einer Klebstoffschicht gebildet ist und einen Kontaktbereich (4) mit der Leiterplattendirektkontaktierung (9) von einem Schaltungsbereich (5) mit dem mindestens einen elektronischen Bauelement (3) abgrenzt.

2. Elektronikeinheit (10) nach Anspruch 1, **dadurch gekennzeichnet, dass** das wärmeleitende Medium (7) ein Pulver, insbesondere ein Keramikpulver, ist.

3. Elektronikeinheit (10) nach Anspruch 1 oder 2, **dadurch gekennzeichnet, dass** die Klebstoffschicht aus einem selbsthärtenden Klebstoff besteht.

4. Elektronikeinheit (10) nach einem der Ansprüche 1 bis 3, **dadurch gekennzeichnet, dass** die Leiterplattendirektkontaktierung (9) ein Stecker zur Ausbildung einer Steckverbindung ist.

5. Verfahren zum Herstellen einer Elektonikeinheit (10) mit einer Leiterplatte (1), die mit wenigstens einem elektronischen Bauelement (3) und einer Leiterplattendirektkontaktierung (9) bestückt ist und in einem Gehäuse (2) angeordnet ist, das mit einem wärmeleitenden Medium (7) befüllt wird, **dadurch gekennzeichnet, dass** auf die Oberfläche des Mediums (7) eine Klebstoffschicht aufgebracht wird, die einen Verschlusspfropfen (8) ausbildet, der einen Kontaktbereich (4) mit der Leiterplattendirektkontaktierung (9) von einem Schaltungsbereich (5) mit dem mindestens einen elektronischen Bauelement (3) abgrenzt.

6. Verfahren nach Anspruch 5, **dadurch gekennzeichnet, dass** als wärmeleitendes Medium (7) ein Pulver, insbesondere ein Keramikpulver, verwendet wird.

7. Verfahren nach Anspruch 5 oder 6, **dadurch gekennzeichnet, dass** das Gehäuse (2) während des Befüllens mit dem wärmeleitenden Medium (7) gerüttelt wird.

8. Verfahren nach einem der Ansprüche 5 bis 7, **dadurch gekennzeichnet, dass** der Klebstoff, insbesondere seine Viskosität, an die Eigenschaften des wärmeleitenden Mediums (7) angepasst ist, so dass im wesentlichen kein Klebstoff in das wärmeleitende Medium (7) gelangt.

9. Verfahren nach einem der Ansprüche 5 bis 8, **dadurch gekennzeichnet, dass** ein selbsthärtender Klebstoff verwendet wird.

## Claims

1. Electronic unit (10), comprising a circuit board (1) loaded with at least one electronic component (3) and a direct circuit-board contacting element (9), the circuit board (1) being arranged in a housing (2), which is filled with a heat-conducting medium (7), **characterized in that** a closure plug (8) is provided, formed by a layer of adhesive and delimiting a contact region (4) with the direct circuit-board contacting element (9) from a circuit region (5) with the at least one electronic component (3).

2. Electronic unit (10) according to Claim 1, **characterized in that** the heat-conducting medium (7) is a powder, in particular a ceramic powder.

3. Electronic unit (10) according to Claim 1 or 2, **characterized in that** the layer of adhesive consists of a self-curing adhesive.

4. Electronic unit (10) according to one of Claims 1 to 3, **characterized in that** the direct circuit-board contacting element (9) is a plug for forming a plug-in connection.

5. Method for producing an electronic unit (10) with a circuit board (1), which is loaded with at least one electronic component (3) and a direct circuit-board contacting element (9) and is arranged in a housing (2), which is filled with a heat-conducting medium (7), **characterized in that** a layer of adhesive is applied to the surface of the medium (7) and forms a closure plug (8), which delimits a contact region (4) with the direct circuit-board contacting element (9) from a circuit region (5) with the at least one electronic component (3).

6. Method according to Claim 5, **characterized in that** a powder, in particular a ceramic powder, is used as the heat-conducting medium (7).

7. Method according to Claim 5 or 6, **characterized in that** the housing (2) is vibrated during the filling with the heat-conducting medium (7).

8. Method according to one of Claims 5 to 7, **characterized in that** the adhesive, in particular the viscosity thereof, is adapted to the properties of the heat-conducting medium (7), so that substantially no adhesive gets into the heat-conducting medium (7).

9. Method according to one of Claims 5 to 8, **characterized in that** a self-curing adhesive is used.

## Revendications

1. Unité électronique (10), comprenant une plaquette de circuits imprimés (1) équipée d'au moins un composant électronique (3) et d'un contact direct de plaquette de circuits imprimés (9), dans laquelle la plaquette de circuits imprimés (1) est disposée dans un boîtier (2), qui est rempli d'un milieu conducteur de la chaleur (7), **caractérisée en ce qu'**il est prévu un bouchon de fermeture (8), qui est formé d'une couche de colle et qui délimite une zone de contact (4) avec le contact direct de plaquette de circuits imprimés (9) par rapport à une zone de circuit (5) avec ledit au moins un composant électronique (3).

2. Unité électronique (10) selon la revendication 1, **caractérisée en ce que** le milieu conducteur de la chaleur (7) est une poudre, en particulier une poudre céramique.

3. Unité électronique (10) selon la revendication 1 ou 2, **caractérisée en ce que** la couche de colle se compose d'une colle autodurcissante.

4. Unité électronique (10) selon l'une quelconque des revendications 1 à 3, **caractérisée en ce que** le contact direct de plaquette de circuits imprimés (9) est un connecteur destiné à réaliser une connexion à fiches.

5. Procédé de fabrication d'une unité électronique (10) avec une plaquette de circuits imprimés (1), qui est équipée d'au moins un composant électronique (3) et d'un contact direct de plaquette de circuits imprimés (9) et qui est disposée dans un boîtier (2), qui est rempli d'un milieu conducteur de la chaleur (7), **caractérisé en ce que** sur la surface du milieu (7) est déposée une couche de colle, qui forme un bouchon de fermeture (8), qui délimite une zone de contact (4) avec le contact direct de plaquette de circuits imprimés (9) par rapport à une zone de circuit (5) avec ledit au moins un composant électronique (3).

6. Procédé selon la revendication 5, **caractérisé en ce que** l'on utilise comme milieu conducteur de la chaleur (7) une poudre, en particulier une poudre céramique.

7. Procédé selon la revendication 5 ou 6, **caractérisé en ce que** l'on secoue le boîtier (2) pendant le remplissage avec le milieu conducteur de la chaleur (7).

8. Procédé selon l'une quelconque des revendications 5 à 7, **caractérisé en ce que** la colle, en particulier sa viscosité, est adaptée aux propriétés du milieu conducteur de la chaleur (7), de telle manière qu'il ne parvienne essentiellement pas de colle dans le milieu conducteur de la chaleur (7).

9. Procédé selon l'une quelconque des revendications 5 à 8, **caractérisé en ce que** l'on utilise une colle autodurcissante.
